# EUROPEAN PATENT APPLICATION

(11) **EP 2 518 772 A1**
(43) Date of publication of application: **31.10.2012**
(21) Application number: 10838848.9
(22) Date of filing: 23.08.2010
(51) Int. Cl.: H01L 29/786, G02F 1/1368, G09F 9/30, H01L 21/336

(54) **ACTIVE MATRIX SUBSTRATE, DISPLAY PANEL PROVIDED WITH SAME, AND METHOD FOR MANUFACTURING ACTIVE MATRIX SUBSTRATE**

(30) Priority: 21.12.2009 JP 2009289116
(71) Applicant: Sharp Kabushiki Kaisha, Osaka-shi, Osaka 545-8522 (JP)
(72) Inventor: CHIKAMA, Yoshimasa, Osaka-shi Osaka 545-8522 (JP); KATSUI, Hiromitsu, Osaka-shi Osaka 545-8522 (JP); NISHIKI, Hirohiko, Osaka-shi Osaka 545-8522 (JP); OHTA, Yoshifumi, Osaka-shi Osaka 545-8522 (JP); MIZUNO, Yuuji, deceased (JP); HARA, Takeshi, Osaka-shi Osaka 545-8522 (JP); AITA, Tetsuya, Osaka-shi Osaka 545-8522 (JP); SUZUKI, Masahiko, Osaka-shi Osaka 545-8522 (JP); TAKEI, Michiko, Osaka-shi Osaka 545-8522 (JP); NAKAGAWA, Okifumi, Osaka-shi Osaka 545-8522 (JP); HARUMOTO, Yoshiyuki, Osaka-shi Osaka 545-8522 (JP)
(74) Representative: Müller - Hoffmann & Partner
(86) International application number: PCT/JP2010/005179
(87) International publication number: WO 2011/077607

(57) **Abstract**

An active matrix substrate includes a plurality of pixel electrodes (P) provided in a matrix, and a plurality of TFTs (5) connected to the pixel electrodes (P). Each of the TFTs (5) includes a gate electrode (11a) provided on an insulating substrate, a gate insulating film (12a) provided to cover the gate electrode (11a), an oxide semiconductor layer (13a) provided on the gate insulating film (12a) to overlap the gate electrode (11a), and a source electrode (17a) and a drain electrode (17b) facing each other and being connected to the oxide semiconductor layer (13a). A protective insulating film (14a) is provided between the oxide semiconductor layer (13a) and the source and drain electrodes (17a) and (17b) to cover the oxide semiconductor layer (13a).

## Description

### TECHNICAL FIELD

The present invention relates to active matrix substrates, display panels including the active matrix substrates, and methods of manufacturing the active matrix substrates, and more particularly to active matrix substrates including thin film transistors using oxide semiconductor, display panels including the active matrix substrates, and methods of manufacturing the active matrix substrates.

### BACKGROUND ART

Active matrix substrates include, as a switching element, for example, a thin film transistor (hereinafter referred to as a "TFT") at every pixel which is a minimum unit of an image.

A conventional TFT includes, for example, a gate electrode provided on an insulating substrate, a gate insulating film to cover the gate electrode, an island-like semiconductor layer provided on the gate insulating film to overlap the gate electrode, and a source electrode and a drain electrode provided on the semiconductor layer to face each other. In a TFT using amorphous silicon, a semiconductor layer includes an intrinsic amorphous silicon layer with a channel region, and an N⁺ amorphous silicon layer stacked on the intrinsic amorphous silicon layer to expose the channel region. As the TFT using amorphous silicon, a TFT of an etching stopper type, which is formed by stacking a channel protection layer on the intrinsic amorphous silicon layer, is in practical use to reduce the thickness of the intrinsic amorphous silicon layer.

For example, Patent Document 1 shows a TFT including a channel protection film (i.e., a channel protection layer) made of silicon nitride on a predetermined position of the upper surface of a semiconductor thin-film made of intrinsic amorphous silicon.

### CITATION LIST

### PATENT DOCUMENT

PATENT DOCUMENT 1: Japanese Patent Publication No. 2002-148658

### SUMMARY OF THE INVENTION

### TECHNICAL PROBLEM

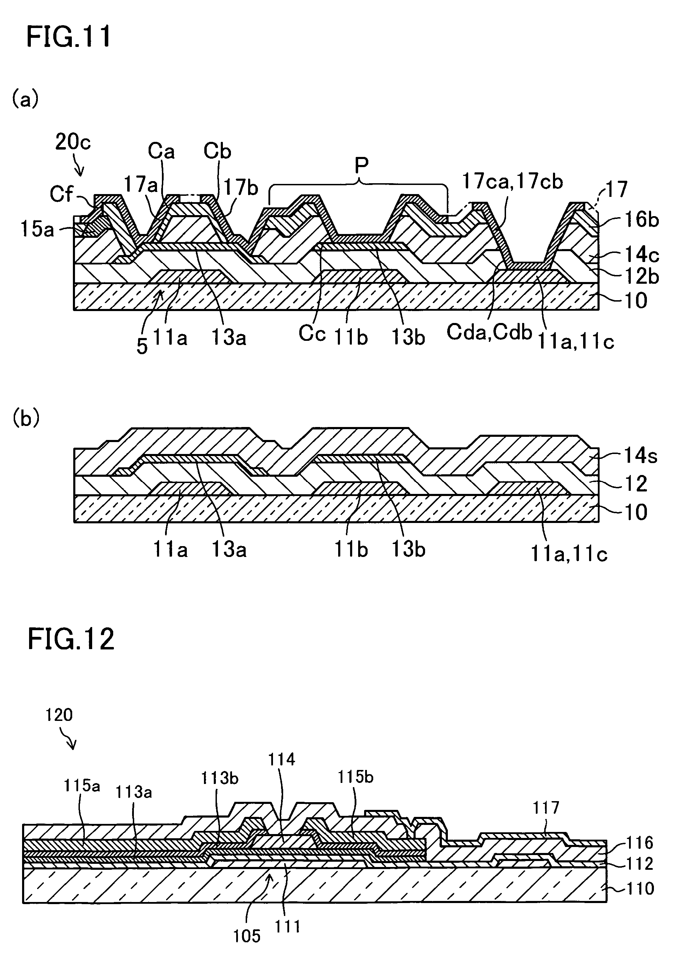

FIG. 12 is a cross-sectional view of a conventional active matrix substrate 120 including a TFT 105 of an etching stopper type.

The active matrix substrate 120 can be manufactured using five photomasks as described below.

First, after a metal film is formed on an insulating substrate 110, the metal film is patterned using the first photomask to form a gate electrode 111.

Then, after a gate insulating film 112, an intrinsic amorphous silicon film to be an intrinsic amorphous silicon layer 113a, and an inorganic insulating film to be a channel protection layer 114 are sequentially formed to cover the gate electrode 111, the inorganic insulating film is patterned using the second photomask to form the channel protection layer 114.

After that, an N⁺ amorphous silicon film to be an N⁺ amorphous silicon layer 113b, and a metal film to be a source electrode 115a and a drain electrode 115b are sequentially formed to cover the channel protection layer 114. Then, the metal film, the underlying N⁺ amorphous silicon film, and the underlying intrinsic amorphous silicon film are patterned using the third photomask to form the intrinsic amorphous silicon layer 113a, the N⁺ amorphous silicon layer 113b, the source electrode 115a, and the drain electrode 115b.

Furthermore, after an inorganic insulating film to be an interlayer insulating film 116 is formed to cover the source electrode 115a and the drain electrode 115b, the inorganic insulating film is patterned using the fourth photomask to form the interlayer insulating film 116 having contact holes.

Finally, after a transparent conductive film to be a pixel electrode 117 is formed to cover the interlayer insulating film 116, the transparent conductive film is patterned using the fifth photomask to form the pixel electrode 117.

With respect to the active matrix substrate 120, the number of the photomasks is reduced to five in view of reducing manufacturing costs, and the N⁺ amorphous silicon film and the intrinsic amorphous silicon film are etched using the channel protection layer 114, the source electrode 115a, and the drain electrode 115b as a mask. Thus, the side end surfaces of the intrinsic amorphous silicon layer 113a are exposed from the source electrode 115a and the drain electrode 115b.

In recent years, TFTs using semiconductor layers of oxide semiconductor have been suggested in place of conventional TFTs using semiconductor layers of amorphous silicon.

Where an active matrix substrate (including TFTs) using a semiconductor layer made of oxide semiconductor is manufactured based on the above-described manufacturing method using the five photomasks, the side end surfaces of the semiconductor layer made of oxide semiconductor, in which numbers of carrier electrons tend to occur due to oxygen deficiency, are exposed from a source electrode and a drain electrode, similar to the active matrix substrate 120 using the semiconductor layer made of amorphous silicon. This may damage the semiconductor layer in etching for forming the source electrode and the drain electrode, and in chemical vapor deposition (CVD) for forming the interlayer insulating film, thereby degrading the characteristics of the TFTs.

The present invention was made in view of the problem. It is an objective of the present invention to reduce degradation in the characteristics of a thin film transistor using a semiconductor layer made of oxide semiconductor without increasing the number of photomasks.

### SOLUTION TO THE PROBLEM

In order to achieve the objective, in the present invention, a protective insulating film is provided between an oxide semiconductor layer and source and drain electrodes to cover the oxide semiconductor layer.

Specifically, an active matrix substrate according to the present invention includes a plurality of pixel electrodes provided in a matrix; and a plurality of thin film transistors connected to the pixel electrodes. Each of the thin film transistors includes a gate electrode provided on an insulating substrate, a gate insulating film provided to cover the gate electrode, an oxide semiconductor layer provided on the gate insulating film to overlap the gate electrode, and a source electrode and a drain electrode provided to face each other and connected to the oxide semiconductor layer. A protective insulating film is provided between the oxide semiconductor layer and the source and drain electrodes to cover the oxide semiconductor layer.

With this structure, in each thin film transistor, the protective insulating film is provided between the oxide semiconductor layer and the source and drain electrodes to cover oxide semiconductor layer. Thus, the oxide semiconductor layer is not exposed to the surface, for example, when pattering the conductive film by etching to form the source electrode (a source line connected to the source electrode) and the drain electrode, and when forming an inorganic insulating film by CVD to form an interlayer insulating film which is an underlying layer of the pixel electrodes. As a result, the oxide semiconductor layer is less likely to be damaged by the etching and the CVD, thereby reducing degradation in the characteristics of the thin film transistor. Also, the active matrix substrate having the above structure is manufactured using four (or five) photomasks in total, since the first photomask is used to form the gate electrode, the second photomask is used to form the oxide semiconductor layer, (in some cases, the third photomask is used to form the source line connected to the source electrode), the third (or fourth) photomask is used to form the protective insulating film, and the fourth (or fifth) photomask is used to form each pixel electrode, the source electrode, and the drain electrode. This reduces degradation in the characteristics of the thin film transistor using the semiconductor layer made of oxide semiconductor without increasing the number of the photomasks.

The drain electrode may be integrally formed with the corresponding pixel electrode. The source electrode may be formed on a same layer and made of a same material as the corresponding pixel electrode.

With this structure, the drain electrode is integrally formed with the corresponding pixel electrode, and the source electrode is formed on the same layer and made of the same material as the pixel electrode. Thus, the pixel electrode, the source electrode, and the drain electrode are formed by patterning a conductive film such as a transparent conductive film.

The active matrix substrate may include a plurality of gate lines provided to extend in parallel; and a plurality of source lines provided to extend in parallel in a direction intersecting the gate lines. The gate insulating film and the protective insulating film may be located at intersections between the gate lines and the source lines.

With this structure, the gate insulating film and the protective insulating film are located at the intersections of the gate lines and the source lines. The thickness of the insulating films located at the intersections of the gate lines and the source lines is increased, thereby reducing source-gate capacitance and source-to-gate short circuits.

The protective insulating film may be a coating-type insulating film.

With this configuration, the protective insulating film is a coating-type insulating film, which tends to be formed with a relatively great thickness. Thus, the source-gate capacitance and the source-to-gate short circuits are further reduced.

An interlayer insulating film may be formed between the pixel electrodes and the protective insulating film.

With this structure, the interlayer insulating film is formed between pixel electrodes and the protective insulating film. Thus, for example, the source lines can be protected by coating the interlayer insulating film.

A display panel according to the present invention includes an active matrix substrate and a counter substrate facing each other; and a display medium layer provided between the active matrix substrate and the counter substrate. The active matrix substrate includes a plurality of pixel electrodes provided in a matrix, and a plurality of thin film transistors connected to the pixel electrodes. Each of the thin film transistors includes a gate electrode provided on an insulating substrate, a gate insulating film provided to cover the gate electrode, an oxide semiconductor layer provided on the gate insulating film to overlap the gate electrode, and a source electrode and a drain electrode provided to face each other and connected to the oxide semiconductor layer. A protective insulating film is provided between the oxide semiconductor layer and the source and drain electrodes to cover the oxide semiconductor layer.

With this structure, in each thin film transistor, the protective insulating film is provided between the oxide semiconductor layer and the source and drain electrodes to cover the oxide semiconductor layer. Thus, the oxide semiconductor layer is not exposed to the surface, for example, when pattering the conductive film by etching to form the source electrode (a source line connected to the source electrode) and the drain electrode, and when forming an inorganic insulating film by CVD to form an interlayer insulating film which is an underlying layer of the pixel electrodes. As a result, the oxide semiconductor layer is less likely to be damaged by the etching and the CVD, thereby reducing degradation in the characteristics of the thin film transistor. Also, the active matrix substrate having the above structure is manufactured using four (or five) photomasks in total, since the first photomask is used to form the gate electrode, the second photomask is used to form the oxide semiconductor layer, (in some cases, the third photomask is used to form the source line connected to the source electrode), the third (or fourth) photomask is used to form the protective insulating film, and the fourth (or fifth) photomask is used to form each pixel electrode, the source electrode, and the drain electrode. This reduces degradation in the characteristics of the thin film transistor using the semiconductor layer made of oxide semiconductor without increasing the number of the photomasks in the display panel including the active matrix substrate and the counter substrate facing each other and the display medium layer provided between the substrates.

The present invention provides a method of manufacturing the active matrix substrate including a plurality of pixel electrodes provided in a matrix, and a plurality of thin film transistors connected to the pixel electrodes. Each of the thin film transistors includes a gate electrode provided on an insulating substrate, and a gate insulating film provided to cover the gate electrode, an oxide semiconductor layer provided on the gate insulating film to overlap the gate electrode, and a source electrode and a drain electrode provided to face each other and connected to the oxide semiconductor layer. The method includes a gate electrode forming step of forming the gate electrode on the insulating substrate; a semiconductor layer forming step of forming the oxide semiconductor layer on the gate insulating film after forming the gate insulating film to cover the gate electrode; a protective insulating film forming step of forming a protective insulating film, which is open in portions in which the oxide semiconductor layer is connected to the source electrode and the drain electrode, by forming an insulating material film to cover the oxide semiconductor layer and then patterning the insulating material film; and a pixel electrode forming step of forming each of the pixel electrodes, the source electrode, and the drain electrode by forming a transparent conductive film to cover the protective insulating film and then patterning the transparent conductive film.

With the above-described method, in the protective insulating film forming step, the insulating material film is formed to cover the oxide semiconductor layer, which has been formed in the semiconductor layer forming step, and then, the insulating material film is patterned to form the protective insulating film, which is open in the portions in which the oxide semiconductor layer is connected to the source electrode and the drain electrode. Thus, in the pixel electrode forming step, the oxide semiconductor layer is not exposed to the surface, for example, when pattering the transparent conductive film by etching to form each pixel electrode, the source electrode, and the drain electrode. As a result, the oxide semiconductor layer is less likely to be damaged by the etching, thereby reducing degradation in the characteristics of the TFT. Also, the active matrix substrate is manufactured using four photomasks in total, since the first photomask is used in the gate electrode forming step, the second photomask is used in the semiconductor layer forming step, and the third photomask is used in the protective insulating film forming step, and the fourth photomask is used in the pixel electrode forming step. This reduces degradation in the characteristics of the thin film transistor using the semiconductor layer made of oxide semiconductor without increasing the number of the photomasks.

In the protective insulating film forming step, the protective insulating film may be formed by forming a metal film to cover the insulating material film and patterning the metal film to form a source line connected to the source electrode, and then patterning the insulating material film.

With the above-described method, in the protective insulating film forming step, the protective insulating film is formed by forming the metal film to cover the insulating material film and patterning the metal film to form the source line, and then patterning the insulating material film. Thus, the oxide semiconductor layer is covered by the insulating material film when the metal film is patterned by etching to form the source line. As a result, the oxide semiconductor layer is less likely to be damaged by the etching of the metal film.

In the protective insulating film forming step, another insulating material film may be formed to cover the insulating material film, and a multilayer film of the insulating material film and the other insulating material film is patterned to form a protective insulating film from the insulating material film and to form an interlayer insulating film, which is an underlying layer of each of the pixel electrodes, the source electrode, and the drain electrode, from the other insulating material film.

With the above-described method, in the protective insulating film forming step, the other (the second) insulating material film is formed to cover the (first) insulating material film, the multilayer film of the (first) insulating material film and the other (second) insulating material film is patterned to form the protective insulating film from the (first) insulating material film and to form the interlayer insulating film from the other (second) insulating material film. Thus, the oxide semiconductor layer is covered by the (first) insulating material film when the other (second) insulating material film is formed by CVD. As a result, the oxide semiconductor layer is less likely to be damaged by the CVD of the other (second) insulating material film.

In the protective insulating film forming step, after a photosensitive resin film is formed on the metal film, the photosensitive resin film may be exposed to light by half exposure to form a resist pattern, which has a relatively great thickness in a portion for forming the source line and is open in portions in which the oxide semiconductor layer is connected to the source electrode and the drain electrode; the metal film exposed from the resist pattern and the insulating material film underlying the metal film may be etched to form the protective insulating film; and the metal film exposed by reducing a thickness of the resist pattern and removing a relatively thin portion may be etched to form the source line.

With the above-described method, the resist pattern, which has the relatively great thickness in the portion for forming the source line and is open in the portions in which the oxide semiconductor layer is connected to the source electrode and the drain electrode, is formed using a single halftone or gray-tone photomask including for example, a transmissive portion, a light-shielding portion, and a semi-transmissive portion, and performing half exposure. The protective insulating film is formed using the resist pattern, and then the source line is formed using the resist pattern with a reduced thickness. This results in reduction in the manufacturing costs of the active matrix.

In the protective insulating film forming step, another insulating material film may be formed to cover the source line and then the other insulating material film is patterned to form an interlayer insulating film which is an underlying layer of each of the pixel electrodes, the source electrode, and the drain electrode.

With the above-described method, in the protective insulating film forming step, the other (second) insulating material film is formed to cover the source line formed on the protective insulating film, and then the other (second) insulating material film is patterned to form the interlayer insulating film. Thus, for example, the depth of the contact holes formed by dry etching prior to the pixel electrode forming step becomes small. This reduces the time for the dry etching, and thus, the surface of the interlayer insulating film is less likely to be damaged. However, where the (second) insulating material film forming the interlayer insulating film is an organic insulating film, damages on the surface of the interlayer insulating film can be further reduced, thereby mitigating reduction in contrast due to the surface roughness of the underlying layer of each pixel electrode.

The insulating material film may be an inorganic insulating film.

With the above-described method, since the insulating material film is an inorganic insulating film, the insulating material film is formed by, for example, CVD, and the inorganic insulating film (i.e., insulating material film) is patterned to actually form the protective insulating film.

### ADVANTAGES OF THE INVENTION

According to the present invention, a protective insulating film is provided between an oxide semiconductor layer and source and drain electrodes to cover an oxide semiconductor layer. Thus, degradation in the characteristics of a thin film transistor using a semiconductor layer made of oxide semiconductor is reduced without increasing the number of photomasks.

### BRIEF DESCRIPTION OF THE DRAWINGS

[FIG. 1] FIG. 1 is a cross-sectional view of a liquid crystal display panel 50 according to a first embodiment.
[FIG. 2] FIG. 2 is a top view of each pixel of an active matrix 20a forming the liquid crystal display panel 50.
[FIG. 3] FIG. 3 is a top view of the portion of the active matrix substrate 20a formed with a gate terminal 17ca.
[FIG. 4] FIG. 4 is a top view of the portion of the active matrix substrate 20a formed with a source terminal 17cb.
[FIG. 5] FIG. 5 is a top view of the portion of the active matrix substrate 20a formed with a gate-source connection 17d.
[FIG. 6] FIG. 6 is a cross-sectional view of a pixel of the active matrix substrate 20a.
[FIG. 7] FIG. 7 is a cross-sectional view of the portion of the active matrix substrate 20a formed with the gate terminal 17ca and the source terminal 17cb.
[FIG. 8] FIG. 8 is a cross-sectional view of the portion of the active matrix substrate 20a formed with the gate-source connection 17d.
[FIG. 9] FIGS. 9A-9F illustrate manufacturing steps of the active matrix substrate 20a.
[FIG. 10] FIGS. 10A-10E illustrate manufacturing steps of an active matrix substrate 20b forming a liquid crystal display panel according to a second embodiment.
[FIG. 11] FIGS. 11A and 11B are cross-sectional views illustrating an active matrix substrate 20c forming a liquid crystal display panel and manufacturing steps of the substrate according to a third embodiment.
[FIG. 12] FIG. 12 is a cross-sectional view of a conventional active matrix substrate 120 including a TFT 105 of an etching stopper type.

### DESCRIPTION OF EMBODIMENTS

Embodiments of the present invention will be described hereinafter with reference to the drawings. Note that the present invention is not limited to the following embodiments.

### First Embodiment of Present Invention

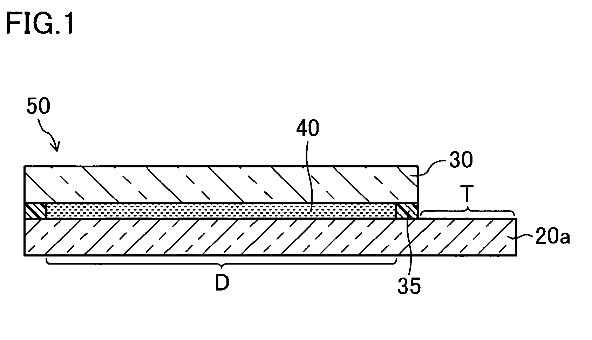

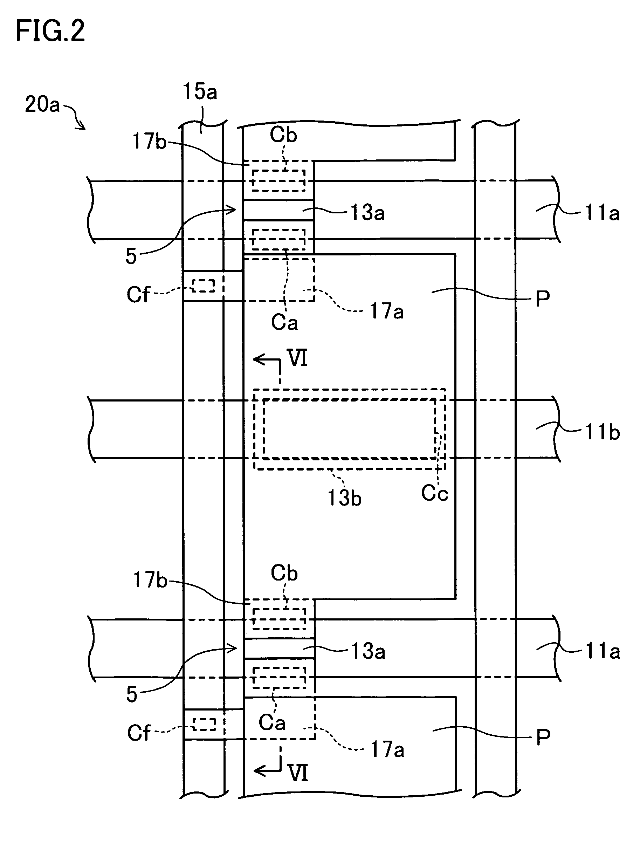

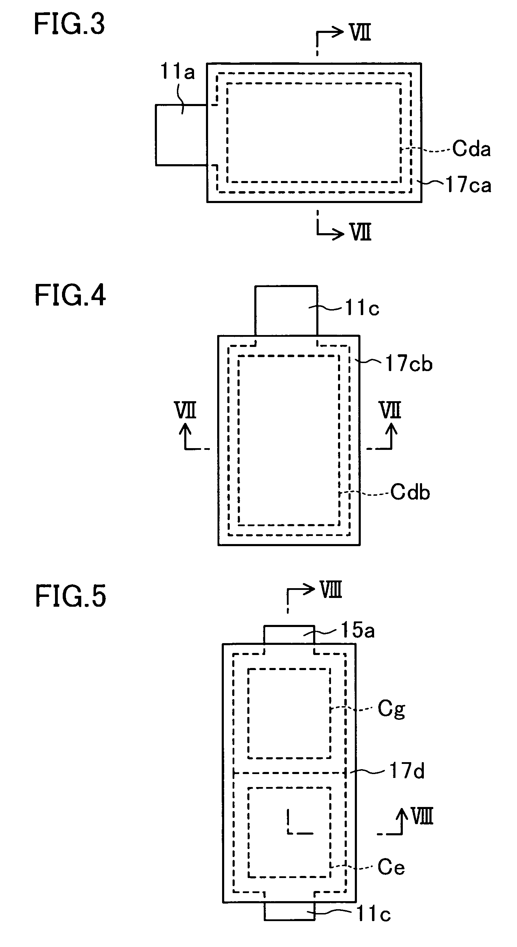

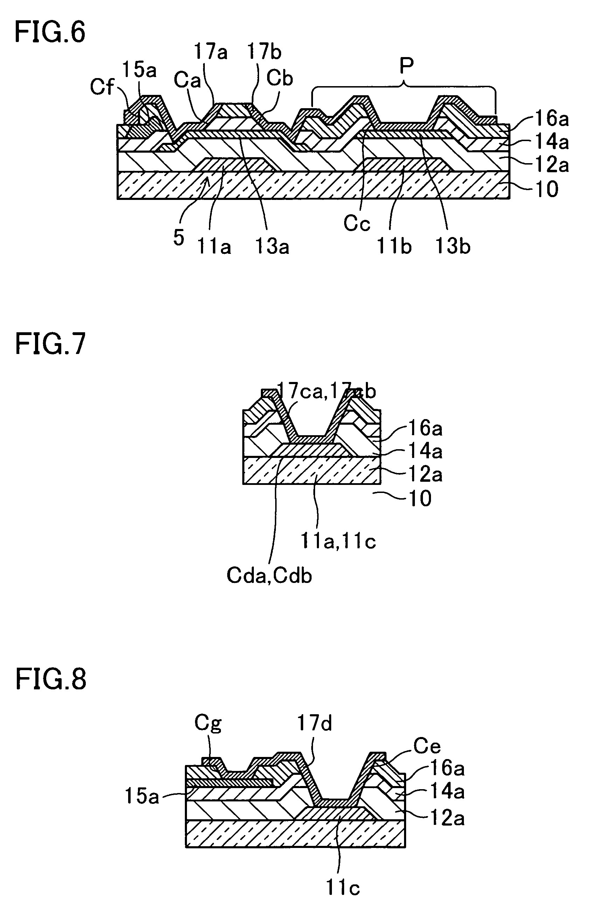

FIGS. 1-9F illustrates an active matrix substrate, a display panel including the active matrix substrate, and a method of manufacturing the active matrix substrate according to a first embodiment of the present invention. Specifically, FIG. 1 is a cross-sectional view of a liquid crystal display panel 50 according to this embodiment. FIG. 2 is a top view illustrating each pixel of the active matrix 20a forming the liquid crystal display panel 50. FIG. 3 is a top view of the portion of the active matrix substrate 20a formed with a gate terminal 17ca. FIG. 4 is a top view of the portion of the active matrix substrate 20a formed with a source terminal 17cb. FIG. 5 is a top view of the portion of the active matrix substrate 20a formed with a gate-source connection 17d. Furthermore, FIG. 6 is a cross-sectional view of a pixel of the active matrix substrate 20a taken along the line VI-VI of FIG. 2. FIG. 7 is a cross-sectional view of the portion of the active matrix substrate 20a formed with the gate terminal 17ca and the source terminal 17cb taken along the lines VII-VII of FIGS. 3 and 4. FIG. 8 is a cross-sectional view of the portion of the active matrix 20a formed with the gate-source connection 17d taken along the line VIII-VIII of FIG. 5.

As shown in FIG. 1, the liquid crystal display panel 50 includes the active matrix substrate 20a and a counter substrate 30 facing each other, a liquid crystal layer 40 provided as a display medium layer between the active matrix substrate 20a and the counter substrate 30, a sealing member 35 bonding the active matrix substrate 20a and the counter substrate 30 together and provided in a frame between the active matrix substrate 20a and the counter substrate 30 to enclose the liquid crystal layer 40.

As shown in FIGS. 2 and 6, the active matrix substrate 20a has a Cs-on-Common structure including a plurality of gate lines 11a provided on the insulating substrate 10 to extend in parallel, a plurality of capacitor lines 11b, each of which is provided between the gate lines 11a and which extend in parallel, a plurality of source lines 15a provided to extend in parallel in a direction orthogonal to the gate lines 11a, a plurality of TFTs 5 provided at the intersections of the gate lines 11a and the source lines 15a, i.e., in each pixel, a plurality of pixel electrodes P provided in a matrix and connected to the TFTs 5, and an alignment film (not shown) provided to cover the pixel electrodes P.

The gate line 11a extends out from a terminal region T (see FIG. 1) located outside the display region D (see FIG. 1) which displays an image. In the terminal region T, as shown in FIGS. 3 and 7, the gate line 11a is connected to the gate terminal 17ca via a contact hole Cda formed in a multilayer film of a gate insulating film 12a, a protective insulating film 14a, and an interlayer insulating film 16a.

The source line 15a extends out from the display region D (see FIG. 1). As shown in FIGS. 5 and 8, the source line 15a is connected to the gate-source connection 17d via a contact hole Cg formed in the interlayer insulating film 16a. The gate-source connection 17d is connected to a relay interconnect 11c via a contact hole Ce formed in the multilayer film of the gate insulating film 12a, the protective insulating film 14a, and the interlayer insulating film 16a. As shown in FIGS. 4 and 7, the relay interconnect 11c is connected to the source terminal 17cb in the terminal region T via a contact hole Cdb formed in the multilayer film of the gate insulating film 12a, the protective insulating film 14a, and the interlayer insulating film 16a.

As shown in FIGS. 2 and 6, each of the TFTs 5 includes a gate electrode (11a) provided on the insulating substrate 10, the gate insulating film 12a provided to cover the gate electrode (11a), an island-like oxide semiconductor layer 13a provided on the gate insulating film 12a in the position corresponding to the gate electrode (11a), and a source electrode 17a and a drain electrode 17b provided to face each other above the oxide semiconductor layer 13a, and connected to the oxide semiconductor layer 13a. As shown in FIG. 6, the protective insulating film 14a is provided between the oxide semiconductor layer 13a and the source and the drain electrodes 17a and 17b to cover the oxide semiconductor layer 13a other than the portions connected to the source electrode 17a and the drain electrode 17b. As shown in FIG. 2, the gate electrode (11a) is a part of the gate line 11a. As shown in FIGS. 2 and 6, the source electrode 17a is connected to the oxide semiconductor layer 13a via a contact hole Ca formed in the multilayer film of the protective insulating film 14a and the interlayer insulating film 16a, and is connected to the source line 15a via a contact hole Cf formed in the interlayer insulating film 16a. As shown in FIGS. 2 and 5, the drain electrode 17b is connected to the oxide semiconductor layer 13a via a contact hole Cb formed in the multilayer film of the protective insulating film 14a and the interlayer insulating film 16a, and extends to a pixel region surrounded by a pair of the adjacent gate lines 11a and a pair of the adjacent source lines 15a to form the pixel electrode P. Furthermore, as shown in FIGS. 2 and 6, the drain electrode 17b is connected to a capacitor electrode 13b via a contact hole Cc formed in the multilayer film of the protective insulating film 14a and the interlayer insulating film 16a. The capacitor electrode 13b overlaps the capacitor lines 11b with the gate insulating film 12a interposed therebetween, thereby forming an auxiliary capacitor. The oxide semiconductor layer 13a is formed of an oxide semiconductor film such as In-Ga-Zn-O (IGZO), In-Si-Zn-O (ISiZO), In-Al-Zn-O (IAIZO), etc.

The counter substrate 30 includes a color filter layer (not shown) including a black matrix (not shown) provided in a lattice on the insulating substrate and color layers (not shown) such as a red color layer, a green color layer, and a blue color layer, which are provided in lattices of the black matrix; a common electrode (not shown) provided to cover the color filter layer; a photo spacer (not shown) provided on the common electrode; and an alignment film (not shown) provided to cover the common electrode.

The liquid crystal layer 40 is formed of, for example, a nematic liquid crystal material having electro-optic properties.

In the liquid crystal display panel 50 having the above-described structure, in each pixel, a gate signal is sent from a gate driver (not shown) to the gate electrode (11a) via the gate line 11a. When the TFT 5 is turned on, a source signal is sent from a source driver (not shown) to the source electrode 17a via the source line 15a, and a predetermined charge is written in the pixel electrode P via the oxide semiconductor layer 13a and the drain electrode 17b. At this time, a potential difference occurs between the pixel electrode P of the active matrix substrate 20a and the common electrode of the counter substrate 30, thereby applying a predetermined voltage to the liquid crystal layer 40, i.e., a liquid crystal capacitor of the pixel and an auxiliary capacitor connected to the liquid crystal capacitor in parallel. In the liquid crystal display panel 50, in each pixel, the alignment state of the liquid crystal layer 40 is changed, depending on the magnitude of the voltage applied to the liquid crystal layer 40, to adjust the light transmittance of the liquid crystal layer 40, thereby displaying an image.

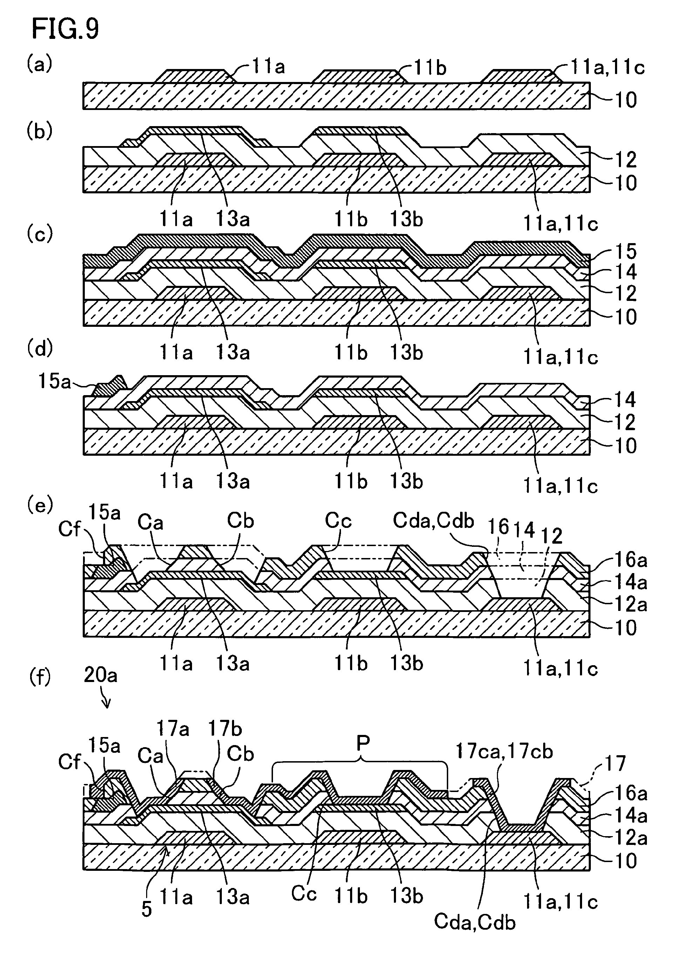

Next, an example method of manufacturing the liquid crystal display panel 50 according to this embodiment will be described hereinafter with reference to FIGS. 9A-9F. FIGS. 9A-9F are cross-sectional views illustrating manufacturing steps of the active matrix substrate 20a. Note that the manufacturing method according to this embodiment includes an active matrix substrate fabricating step, a counter substrate fabricating step, and a liquid crystal injecting step.

### Active Matrix Substrate Fabricating Step

First, a first metal film, which is formed by sequentially stacking, for example, a titanium film (with a thickness of about 50 nm), an aluminum film (with a thickness of about 200 nm), and a titanium film (with a thickness of about 100 nm), is formed by sputtering on the entire insulating substrate 10 such as a glass substrate. Then, photolithography using a first photomask, dry etching of the first metal film, resist removal, and cleaning are performed to form the gate line (gate electrode) 11 a, the capacitor line 11b, and the relay interconnect 11c as shown in FIG. 9A (gate electrode forming step).

Then, an inorganic insulating film 12 such as a silicon oxide film (with a thickness of about 200 nm-500 nm) is formed by chemical vapor deposition (CVD) on the entire surface, on which the gate line (gate electrode) 11 a, the capacitor line 11b, and the relay interconnect 11c have been formed. After that, for example, an IGZO oxide semiconductor film (with a thickness of about 30 nm-300 nm) is formed by sputtering. Then, photolithography using a second photomask, wet etching of the oxide semiconductor film, resist removal, and cleaning are performed to form the oxide semiconductor layer 13a and the capacitor electrode 13b as shown in FIG. 9B (semiconductor layer forming step). While in this embodiment, an example has been described where the inorganic insulating film 12 is the single-layer, the inorganic insulating film 12 may be a multilayer including, for example, a silicon nitride film (with a thickness of about 200 nm-500 nm) as a lower layer, and a silicon oxide film (with a thickness of about, e.g., 20 nm-150 nm) as an upper layer.

Next, as shown in FIG. 9C, a first inorganic insulating film (insulating material film) 14 such as a silicon oxide film (with a thickness of about 50 nm-200 nm) is formed by CVD on the entire substrate, on which the oxide semiconductor layer 13a and the capacitor electrode 13b have been formed. Then, a second metal film 15 is formed by sputtering, which is formed by sequentially stacking for example, a titanium film (with a thickness of about 50 nm), an aluminum film (with a thickness of about 200 nm), and a titanium film (with a thickness of about 100 nm). After that, photolithography using a third photomask, dry etching of the second metal film 15, resist removal, and cleaning are performed to form the source line 15a as shown in FIG. 9D. While in this embodiment, an example has been described where the first inorganic insulating film 14 is the single-layer, the first inorganic insulating film 14 may be a multilayer including, for example, a silicon oxide film as a lower layer, and a silicon nitride film as an upper layer.

After that, a second inorganic insulating film (i.e., another insulating material film) 16 such as a silicon oxide film (with a thickness of 50 nm-300 nm) is formed by CVD on the entire substrate, on which the source line 15a has been formed. Then, photolithography using a fourth photomask, wet etching of the second inorganic insulating film 16, wet etching of the multilayer film of the first inorganic insulating film 14 and the second inorganic insulating film 16, wet etching of the multilayer film of the inorganic insulating film 12, the first inorganic insulating film 14, and the second inorganic insulating film 16, resist removal, and cleaning are performed to form the contact holes Ca, Cb, Cc, Cda, Cdb, Ce (see FIG. 8), Cf, and Cg (see FIG. 8) as shown in FIG. 9E to form the gate insulating film 12a, the protective insulating film 14a, and the interlayer insulating film 16a (protective insulating film forming step). While in this embodiment, an example has been described where the second inorganic insulating film 16 is the single layer, the second inorganic insulating film 16 may be a multilayer including, for example, a silicon oxide film as a lower layer, and a silicon nitride film as an upper layer.

Then, a transparent conductive film 17 such as an indium tin oxide (ITO) film (with a thickness of about 100 nm) is formed by sputtering on the entire substrate, on which the gate insulating film 12a, the protective insulating film 14a, and the interlayer insulating film 16a have been formed. Then, photolithography using a fifth photomask, dry etching of the transparent conductive film 17, resist removal, and cleaning are performed to form the source electrode 17a, the drain electrode 17b (the pixel electrode P), the gate terminal 17ca, the source terminal 17cb, and the gate-source connection 17d (see FIG. 8) as shown in FIG. 9F (pixel electrode forming step).

Finally, a polyimide resin is applied by printing on the entire substrate, on which the source electrode 17a, the drain electrode 17b (the pixel electrode P), the gate terminal 17ca, the source terminal 17cb, and the gate-source connection 17d have been formed. Rubbing is then performed to form an alignment film with a thickness of about 100 nm.

As described above, the active matrix substrate 20a can be fabricated.

### Counter Substrate Fabricating Step

First, for example, an acrylic photosensitive resin dispersed with, e.g., carbon particles, is applied by spin coating on the entire substrate of an insulating substrate such as a glass substrate. After the applied photosensitive resin is exposed to light via a photomask and developed, a black matrix is formed with a thickness of about 1.5 µm.

Next, for example, a red-, green-, or blue-colored acrylic photosensitive resin is applied by spin coating on the entire substrate, on which the black matrix has been formed. The applied photosensitive resin is exposed to light via a photomask and developed to be patterned, thereby forming a color layer (e.g., a red color layer) of the selected color with a thickness of about 2.0 µm. Similar steps are repeated for the other two colors to form color layers (e.g., a green color layer and a blue color layer) of the other two colors with a thickness of 2.0 µm, thereby forming a color filter layer.

Furthermore, a transparent conductive film such as an ITO film is formed by sputtering on the substrate, on which the color filter layer has been formed, to form a common electrode with a thickness of about 100 nm.

After that, the photosensitive resin is applied by spin coating on the entire substrate, on which the common electrode has been formed. The applied photosensitive resin is exposed to light via a photomask and developed to form a photo spacer with a thickness of about 4 µm.

Finally, a polyimide resin is applied by printing on the entire substrate, on which the photo spacer has been formed. Rubbing is then performed to form an alignment film with a thickness of about 100 nm.

As described above, the counter substrate 30 can be fabricated.

### Liquid Crystal Injecting Step

First, the sealing member 35 made of, for example, a UV and thermal curing resin is formed in a frame on the counter substrate 30, which has been fabricated in the counter substrate fabricating process, using, for example, a dispenser.

Next, a liquid crystal material is dropped into a region inside the sealing member 35 of the counter substrate 30 on which the sealing member has been formed.

Moreover, the counter substrate 30, on which the liquid crystal material has been dropped, and the active matrix substrate 20a, which has been formed in the active matrix substrate fabricating process, are bonded together under reduced pressure. Then, the bonded body is exposed to the atmosphere to apply pressure on the front and back surfaces of the bonded body.

Finally, the sealing member 35 interposed between the substrates of the bonded body is irradiated with UV light and then heated, thereby curing the sealing member 35.

As such, the liquid crystal display panel 50 according to this embodiment can be manufactured.

As described above, in the active matrix substrate 20a, the liquid crystal display panel 50 including the active matrix substrate 20a, and a method of manufacturing the active matrix substrate 20a according to this embodiment, in the protective insulating film forming step, after the first inorganic insulating film 14 is formed to cover the oxide semiconductor layer 13a, which has been formed in the semiconductor layer forming step, the first inorganic insulating film 14 is patterned to form the protective insulating film 14a, which is open in the portions in which the oxide semiconductor layer 13a is connected to the source electrode 17a and the drain electrode 17b. In the pixel electrode forming step, in order to form each pixel electrode P, the source electrode 17a, and the drain electrode 17b, the oxide semiconductor layer 13a is not exposed to the surface when patterning the transparent conductive film 17 by etching. Thus, the oxide semiconductor layer 13a is less likely to be damaged by the etching, thereby reducing degradation in the characteristics of the TFTs 5. In the protective insulating film forming step, the second metal film 15 is formed to cover the first inorganic insulating film 14, the second metal film 15 is patterned to form the source line 15a, and then, the first inorganic insulating film 14 is patterned to form the protective insulating film 14a. Thus, when the second metal film 15 is patterned by etching to form the source line 15a, the oxide semiconductor layer 13a is covered by the first inorganic insulating film 14. As a result, the oxide semiconductor layer 13a is less likely to be damaged by the etching of the second metal film 15. Moreover, in the protective insulating film forming step, the second inorganic insulating film 16 is formed to cover the first inorganic insulating film 14, and the multilayer film of the first inorganic insulating film 14 and the second inorganic insulating film 16 is patterned to form the protective insulating film 14a from the first inorganic insulating film 14, and the interlayer insulating film 16a is formed from the second inorganic insulating film 16. Thus, when the second inorganic insulating film 16 is formed by CVD, the oxide semiconductor layer 13a is covered by the first inorganic insulating film 14. As a result, the oxide semiconductor layer 13a is less likely to be damaged by the CVD of the second inorganic insulating film 16. The active matrix substrate 20a is manufactured using five photomasks in total, since the first photomask is used in the gate electrode forming step, the second photomask is used in the semiconductor layer forming step, the third and fourth photomasks are used in the protective insulating film forming step, and the fifth photomask is used in the pixel electrode forming step. Therefore, in the active matrix substrate 20a and the liquid crystal display panel 50 including the active matrix substrate 20a, degradation in the characteristics of the TFT using the semiconductor layer made of oxide semiconductor can be reduced without increasing the number of the photomasks.

In the active matrix substrate 20a according to this embodiment, the drain electrode 17b is integrally formed with each pixel electrode P, the source electrode 17a is formed on a same layer and made of a same material as each pixel electrode P. Thus, the pixel electrodes P, the source electrode 17a, and the drain electrode 17b can be formed by pattering a conductive film such as the transparent conductive film 17.

In the active matrix substrate 20a according to this embodiment, the gate insulating film 12a and the protective insulating film 14a are located at the intersections of the gate lines 11a and the source lines 15a. Thus, the thicknesses of the insulating films located at the intersections of the gate lines 11a and the source lines 15a are increased, thereby reducing source-gate capacitance and source-to-gate short circuits.

In this embodiment, an example has been described where the five photomasks are used in the method of manufacturing the active matrix substrate 20a. Instead, the formation and the patterning of the second metal film 15 may be omitted, and the source lines (15a) provided in the metal film 15 may be formed on a same layer and made of a same material (i.e., the transparent conductive film 17) as each pixel electrode P. As a result, the active matrix substrate can be manufactured using four photomasks.

### Second Embodiment of Invention

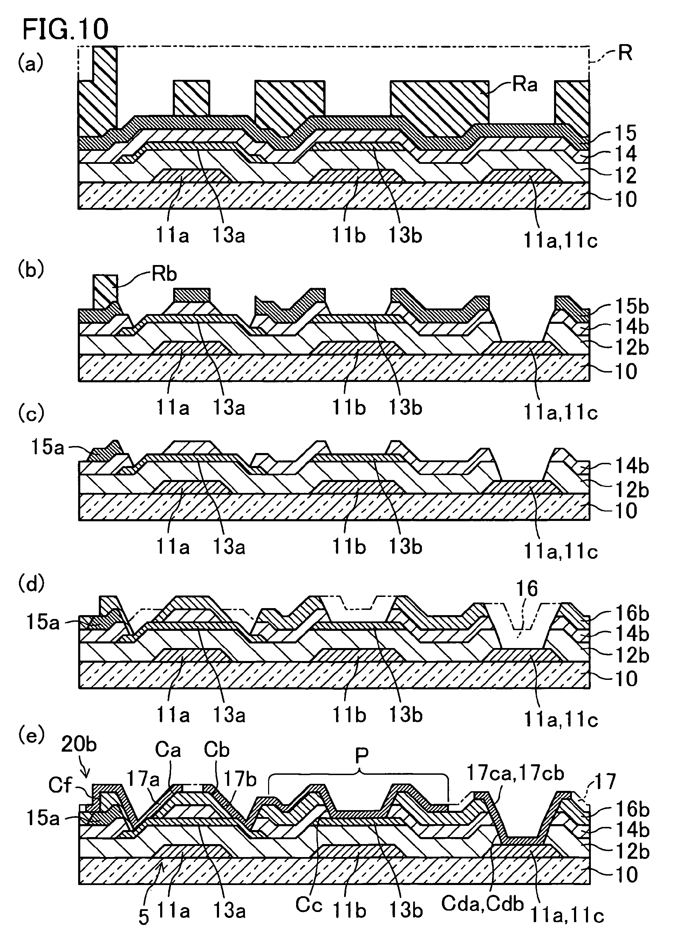

FIGS. 10A-10E illustrate manufacturing steps of an active matrix substrate 20b forming a liquid crystal display panel of this embodiment. In the following embodiment, the same reference characters as those shown in FIGS. 1-9F are used to represent equivalent elements, and the detailed explanation thereof will be omitted.

The liquid crystal display panel according to this embodiment includes the active matrix substrate 20b and the counter substrate 30 (see FIG. 1) facing each other, and the liquid crystal layer 40 (see FIG. 1) provided between the active matrix substrate 20b and the counter substrate 30.

In the active matrix substrate 20b, as shown in FIG. 10E, each of TFTs 5 includes a gate electrode (11a) provided on an insulating substrate 10, a gate insulating film 12b provided to cover the gate electrode (11a), an island-like oxide semiconductor layer 13a provided on the gate insulating film 12b and in the position corresponding to the gate electrode (11a), and a source electrode 17a and a drain electrode 17b provided to face each other above the oxide semiconductor layer 13a, and connected to the oxide semiconductor layer 13a. As shown in FIG. 10E, the protective insulating film 14b is provided between the oxide semiconductor layer 13a and the source and drain electrodes 17a and 17b to cover the oxide semiconductor layer 13a other than the portions connected to the source electrode 17a and the drain electrode 17b. As shown in FIG. 10E, the source electrode 17a is connected to the oxide semiconductor layer 13a via a contact hole Ca formed in (the protective insulating film 14b and) the interlayer insulating film 16b, and is connected to the source line 15a via a contact hole Cf formed in the interlayer insulating film 16b. As shown in FIG. 10E, the drain electrode 17b is connected to the oxide semiconductor layer 13a via a contact hole Cb formed in (the protective insulating film 14b and) the interlayer insulating film 16b, and extends to a pixel region to form a pixel electrode P.

Next, an example method of manufacturing the active matrix substrate 20b according to this embodiment will be described with reference to FIGS. 10A-10E. Note that, in the manufacturing method according to this embodiment, only the protective insulating film forming step of the active matrix substrate fabricating step is changed from the first embodiment. An example will be thus described focusing on the protective film forming step.

First, the semiconductor layer forming step of the active matrix substrate fabricating step of the first embodiment is performed to from the oxide semiconductor layer 13a and the capacitor electrode 13b. A first inorganic insulating film (insulating material film) 14 such as a silicon oxide film (with a thickness of about 50 nm-200 nm) is formed by CVD on the entire substrate, on which the oxide semiconductor layer 13a and the capacitor electrode 13b have been formed, as shown in FIG. 10A. Then, a second metal film 15 is formed by sputtering, which is formed by sequentially stacking for example, a titanium film (with a thickness of about 50 nm), an aluminum film (with a thickness of about 200 nm), a titanium film (with a thickness of about 100 nm), etc. Moreover, a photosensitive resin film R is applied by spin coating. After the applied photosensitive resin film R is exposed to light via a halftone third photomask and developed to form a resist pattern Ra, which has a relatively great thickness in a portion for forming the source line 15a and is open in portions for forming the contact holes Ca, Cb, Cc, Cda and Cdb, as shown in FIG. 10A.

Then, the second metal film 15 exposed from the resist pattern Ra, the underlying first inorganic insulating film 14, and the underlying inorganic insulating film 12 are dry etched to form the gate insulating film 12b, the protective insulating film 14b, and the metal layer 15b as shown in FIG. 10B.

The thickness of the resist pattern Ra is reduced by ashing, thereby removing a portion of the resist pattern Ra with a relatively small thickness to form a resist pattern Rb as shown in FIG. 10B. After that, dry etching of the metal layer 15b exposed from the resist pattern Rb, resist removal, and cleaning are performed to form the source line 15a as shown in FIG. 10C.

Then, a second inorganic insulating film (the other insulating material film) 16 such as a silicon oxide film (with a thickness of 50 nm-300 nm) is formed by CVD on the entire substrate, on which the source line 15a has been formed. After that, photolithography using a fourth photomask, wet etching of the second inorganic insulating film 16, resist removal, and cleaning are performed to form an interlayer insulating film 16b as shown in FIG. 10D (protective insulating film forming step).

Moreover, a transparent conductive film 17 such as an ITO film (with a thickness of about 100 nm) is formed by sputtering on the entire substrate, on which the interlayer insulating film 16b has been formed. After that, photolithography using a fifth photomask, dry etching of the transparent conductive film 17, resist removal, and cleaning are performed to form the source electrode 17a, the drain electrode 17b (the pixel electrode P), the gate terminal 17ca, the source terminal 17cb, etc. as shown in FIG. 10E (pixel electrode forming step).

Finally, a polyimide resin is applied by printing on the entire substrate, on which the source electrode 17a, the drain electrode 17b (the pixel electrode P), the gate terminal 17ca, the source terminal 17cb, etc. have been formed. Rubbing is then performed to form an alignment film with a thickness of about 100 nm.

As such, the active matrix substrate 20b can be fabricated.

As described above, in the active matrix substrate 20b, the liquid crystal display panel including the active matrix substrate 20b, and the method of manufacturing the active matrix substrate 20a according to this embodiment, similar to the first embodiment, the protective insulating film 14b is provided between the source electrode 17a and the drain electrode 17b, and the oxide semiconductor layer 13a to cover the oxide semiconductor layer 13a. Thus, degradation in the characteristics of the TFT using the semiconductor layer made of oxide semiconductor can be reduced without increasing the number of the photomasks.

In the method of manufacturing the active matrix substrate 20b according to this embodiment, the resist pattern Ra, which has a relatively great thickness in a portion for forming the source line 15a and is open in portions in which the oxide semiconductor layer 13a is connected to the source electrode 17a and the drain electrode 17b, is formed using a single halftone (or gray-tone) photomask including for example, a transmissive portion, a light-shielding portion, and a semi-transmissive portion, and performing half exposure. The protective insulating film 14b is formed using the resist pattern Ra. Since the source line 15a is provided using the resist pattern Rb, which is formed by reducing the thickness of the resist pattern Ra, the manufacturing costs of the active matrix substrate 20b can be reduced.

In the method of manufacturing the active matrix substrate 20b according to this embodiment, in the protective insulating film forming step, after the second inorganic insulating film 16 is formed to cover the source line 15a formed on the protective insulating film 14b, the second inorganic insulating film 16 is patterned to form the interlayer insulating film 16b. Thus, for example, the depth of the contact holes becomes small, which is formed by dry etching prior to the pixel electrode forming step. This reduces the time for the dry etching, and thus, the surface of the interlayer insulating film 16b is less likely to be damaged. In this embodiment, the interlayer insulating film 16a is an inorganic insulating film. However, where the interlayer insulating film is an organic insulating film, damages on the surface of the interlayer insulating film can be further reduced, thereby mitigating reduction in contrast due to the surface roughness of the underlying layer of the pixel electrode.

In the active matrix substrate 20b according to this embodiment, the gate insulating film 12b and the protective insulating film 14b are located at the intersections of the gate lines 11a and the source lines 15a. The thicknesses of the insulating films located at the intersections of the gate lines 11a and the source lines 15a are increased, thereby reducing source-gate capacitance and source-to-gate short circuits.

### Third Embodiment of Invention

FIG. 11A is a cross-sectional view of an active matrix substrate 20c forming the liquid crystal display panel according to this embodiment. FIG. 11B is a cross-sectional view illustrating a part of a manufacturing step of the active matrix substrate 20c.

In the first and second embodiments, an example has been described where the insulating material films forming the protective insulating film 14a and 14b are formed by CVD. In this embodiment, the insulating material film forming a protective insulating film 14c is formed by applying and baking an organic resin.

The liquid crystal display panel according to this embodiment includes the active matrix substrate 20c and the counter substrate 30 (see FIG. 1) facing each other, and the liquid crystal layer 40 (see FIG. 1) provided between the active matrix substrate 20c and the counter substrate 30.

In the active matrix substrate 20c, as shown in FIG. 11A, the protective insulating film 14c is provided between an oxide semiconductor layer 13a and source and drain electrodes 17a and 17b of a TFT 5 to cover the oxide semiconductor layer 13a other than the portions connected to the source electrode 17a and the drain electrode 17b. As shown in FIG. 11A, the source electrode 17a is connected to the oxide semiconductor layer 13a via a contact hole Ca formed in (the protective insulating film 14c and) the interlayer insulating film 16b, and is connected to the source line 15a via a contact hole Cf formed in the interlayer insulating film 16b. As shown in FIG. 11A, the drain electrode 17b is connected to the oxide semiconductor layer 13a via a contact hole Cb formed in (the protective insulating film 14c and) the interlayer insulating film 16b, and extends to a pixel region to from a pixel electrode P. Furthermore, the protective insulating film 14c has a thickness of about 1.5 µm, and is a coating-type insulating film with a greater thickness than the protective insulating films 14a and 14b of the first and second embodiments.

The active matrix substrate 20c according to this embodiment can be manufactured by changing the method of forming the first inorganic insulating film 14 in the protective insulating film forming step of the second embodiment to the method of forming an organic insulating film 14s by performing pre-bake for about 5 minutes at a temperature of 150°C and post-bake for about 1 hour at a temperature of 200°C after applying an acrylic resin with a thickness of about 1.5 µm by spin coating on the entire substrate, on which the oxide semiconductor layer 13a and the capacitor electrode 13b have been formed, as shown in FIG. 11B.

As described above, in the active matrix substrate 20c, the liquid crystal display panel including the active matrix substrate 20c, and the method of manufacturing the active matrix substrate 20c according to this embodiment, similar to the first and second embodiments, the protective insulating film 14c is provided between the oxide semiconductor layer 13a and the source and drain electrodes 17a and 17b to cover the oxide semiconductor layer 13a. Thus, degradation in the characteristics of the TFT using the semiconductor layer made of oxide semiconductor can be reduced without increasing the number of photomasks.

In the active matrix substrate 20c according to this embodiment, the gate insulating film 12b and the protective insulating film 14c are located at intersections of gate lines 11a and the source lines 15a, and the protective insulating film 14c is a coating-type insulating film, which tends to be formed with a relatively great thickness. Thus, the thicknesses of the insulating films located at the intersection of the gate lines 11a and the source lines 15a are further increased, thereby further reducing source-gate capacitance and source-to-gate short circuits.

In the above described embodiments, an example has been described where the interlayer insulating film 16a and 16b are provided on the protective insulating film 14a, 14b, and 14c. Instead, in the present invention, the interlayer insulating film 16a and 16b on the protective insulating film 14a, 14b, and 14c may be omitted.

In the above described embodiments, an example has been described where the active matrix substrate has a Cs-on-Common structure. The present invention is also applicable to an active matrix substrate having a Cs-on-Gate structure.

In the above described embodiments, an example active matrix substrate has been described where the electrode of the TFT connected to each pixel electrode is a drain electrode. The present invention is also applicable to an active matrix substrate in which an electrode of a TFT connected to each pixel electrode is called a "source electrode."

### INDUSTRIAL APPLICABILITY

As described above, the present invention reduces degradation in the characteristics of a TFT using a semiconductor layer made of oxide semiconductor without increasing the number of photomasks, and is thus useful for a liquid crystal display panel of an active matrix driven type including a TFT.

### DESCRIPTION OF REFERENCE CHARACTERS

- P: Pixel Electrode
- R: Photosensitive Resin Film
- Ra, Rb: Resist Patterns
- 5: TFT
- 10: Insulating Substrate
- 11a: Gate Line (Gate Electrode)
- 12a: Gate Insulating Film
- 13a: Oxide Semiconductor Layer
- 14: First Inorganic Insulating Film (Insulating Material Film)
- 14a, 14b, 14c: Protective Insulating Films
- 15: Metal Film
- 15a: Source Line
- 16: Second Inorganic Insulating Film (Another Insulating Material Film)
- 16a: Interlayer Insulating Film
- 17: Transparent Conductive Film
- 17a: Source Electrode
- 17b: Drain Electrode
- 20a, 20b, 20c: Active Matrix Substrates
- 30: Counter Substrate
- 40: Liquid Crystal Layer (Display Medium Layer)
- 50: Liquid Crystal Display Panel

## Claims

1. An active matrix substrate comprising:
a plurality of pixel electrodes provided in a matrix; and
a plurality of thin film transistors connected to the pixel electrodes, wherein
each of the thin film transistors includes
a gate electrode provided on an insulating substrate,
a gate insulating film provided to cover the gate electrode,
an oxide semiconductor layer provided on the gate insulating film to overlap the gate electrode, and
a source electrode and a drain electrode provided to face each other and connected to the oxide semiconductor layer, and
a protective insulating film is provided between the oxide semiconductor layer and the source and drain electrodes to cover the oxide semiconductor layer.

2. The active matrix substrate of claim 1, wherein
the drain electrode is integrally formed with the corresponding pixel electrode, and
the source electrode is formed on a same layer and made of a same material as the corresponding pixel electrode.

3. The active matrix substrate of claim 1 or 2, further comprising
a plurality of gate lines provided to extend in parallel; and
a plurality of source lines provided to extend in parallel in a direction intersecting the gate lines, wherein
the gate insulating film and the protective insulating film are located at intersections between the gate lines and the source lines.

4. The active matrix substrate of claim 3, wherein the protective insulating film is a coating-type insulating film.

5. The active matrix substrate of any one of claims 1-4, wherein an interlayer insulating film is provided between the pixel electrodes and the protective insulating film.

6. A display panel comprising:
an active matrix substrate and a counter substrate facing each other; and
a display medium layer provided between the active matrix substrate and the counter substrate, wherein
the active matrix substrate includes
a plurality of pixel electrodes provided in a matrix, and
a plurality of thin film transistors connected to the pixel electrodes,
each of the thin film transistors includes
a gate electrode provided on an insulating substrate,
a gate insulating film provided to cover the gate electrode,
an oxide semiconductor layer provided on the gate insulating film to overlap the gate electrode, and
a source electrode and a drain electrode provided to face each other and connected to the oxide semiconductor layer, and
a protective insulating film is provided between the oxide semiconductor layer and the source and drain electrodes to cover the oxide semiconductor layer.

7. A method of manufacturing an active matrix substrate including a plurality of pixel electrodes provided in a matrix, and a plurality of thin film transistors connected to the pixel electrodes, where each of the thin film transistors includes a gate electrode provided on an insulating substrate, a gate insulating film provided to cover the gate electrode, an oxide semiconductor layer provided on the gate insulating film to overlap the gate electrode, and a source electrode and a drain electrode provided to face each other and connected to the oxide semiconductor layer, the method comprising:
a gate electrode forming step of forming the gate electrode on the insulating substrate;
a semiconductor layer forming step of forming the oxide semiconductor layer on the gate insulating film after forming the gate insulating film to cover the gate electrode;
a protective insulating film forming step of forming a protective insulating film, which is open in portions in which the oxide semiconductor layer is connected to the source electrode and the drain electrode, by forming an insulating material film to cover the oxide semiconductor layer and patterning the insulating material film; and
a pixel electrode forming step of forming each of the pixel electrodes, the source electrode, and the drain electrode by forming a transparent conductive film to cover the protective insulating film and then patterning the transparent conductive film.

8. The method of manufacturing the active matrix substrate of claim 7, wherein
in the protective insulating film forming step, the protective insulating film is formed by forming a metal film to cover the insulating material film and patterning the metal film to form a source line connected to the source electrode, and then patterning the insulating material film.

9. The method of manufacturing the active matrix substrate of claim 7 or 8, wherein
in the protective insulating film forming step, another insulating material film is formed to cover the insulating material film, and a multilayer film of the insulating material film and the other insulating material film is patterned to form a protective insulating film from the insulating material film and to form an interlayer insulating film, which is an underlying layer of each of the pixel electrodes, the source electrode, and the drain electrode, from the other insulating material film.

10. The method of manufacturing the active matrix substrate of claim 8, wherein
in the protective insulating film forming step, after a photosensitive resin film is formed on the metal film, the photosensitive resin film is exposed to light by half exposure to form a resist pattern, which has a relatively great thickness in a portion for forming the source line, and is open in portions in which the oxide semiconductor layer is connected to the source electrode and the drain electrode; the metal film exposed from the resist pattern and the insulating material film underlying the metal film are etched to form the protective insulating film; and the metal film exposed by reducing a thickness of the resist pattern and removing a relatively thin portion is etched to form the source line.

11. The method of manufacturing the active matrix substrate of claim 10, wherein
in the protective insulating film forming step, after another insulating material film is formed to cover the source line, the other insulating material film is patterned to form an interlayer insulating film which is an underlying layer of each of the pixel electrodes, the source electrode, and the drain electrode.

12. The method of manufacturing the active matrix substrate of any one of claims 7-11, wherein the insulating material film is an inorganic insulating film.
